Europäisches Patentamt

European Patent Office

Office européen des brevets

(19)

(11) Publication number: 0 416 982 A2

# EUROPEAN PATENT APPLICATION

(21) Application number: 90402392.6

(22) Date of filing: 29.08.90

(51) Int. Cl.5: H01L 21/00

(30) Priority: 05.09.89 US 402479

(43) Date of publication of application:
13.03.91 Bulletin 91/11

(84) Designated Contracting States:
DE FR NL

(71) Applicant: PACIFIC WESTERN SYSTEMS, Inc.
505 E, Evelyn Avenue
Mountain View, California 94041(US)

(72) Inventor: Engle, George M.
c/o Pacific West. Syst., Inc., 505 E. Evelyn
Ave.
Mountain View, California 94041(US)
Inventor: Pijaszek, Robert F.
c/o Pacific West. Syst., Inc., 505 E. Evelyn
Ave.
Mountain View, California 94041(US)

(74) Representative: Kopacz, William James
83, Avenue Foch
F-75116 Paris(FR)

(54) Plasma enhanced chemical vapor deposition/etching improved uniformity by electrode modifications.

(57) A plasma enhanced chemical vapor deposition/etching electrode member for supporting semiconductor wafers within a gas plasma field for chemical vapor deposition or etching treatment. The electrode member comprises a relatively flat member, having a electrically conductive surfaces and at least one centrally disposed wafer support surface formed thereon for receiving and supporting the complimentary-shaped semiconductor wafer for treatment. The electrode member is shaped in the area of the wafer support surface near but inside the circumferential edge of any wafer supported thereon to provide a reduced thickness circumferential electrode region whereby increased electric field force density is obtained around the circumferential regions of the wafer supported on the electrode during treatment to provide improved uniformity of deposition and/or etching. Additionally, triangular-shaped, pin-like supports are provided for the wafers during treatment to reduce to a minimum any shadow-effects that might be induced on the surfaces of the wafers by the support pins.

FIG.2A

# PLASMA ENHANCED CHEMICAL VAPOR DEPOSITION/ETCHING IMPROVED UNIFORMITY BY ELECTRODE MODIFICATIONS

## FIELD OF INVENTION

This invention relates to a new and improved plasma enhanced chemical vapor deposition electrode for supporting semiconductor wafers within a gaseous plasma electric field for obtaining more uniform chemical vapor deposition or etching treatment of the surfaces of semiconductor wafers during fabrication of semiconductor devices.

## BACKGROUND PROBLEM

The present practice in the fabrication of semiconductor devices utilizing plasma enhanced chemical vapor deposition/etching techniques is to place the semiconductor wafer being coated or etched on an electrode and adjusting the process to improve the uniformity. These techniques can produce uniformities in the plus/minus 5% range.

When coating or etching a semiconductor wafer during the processing of the wafer into a integrated circuit structure using the above briefly described plasma enhanced chemical vapor deposition/etching techniques, the outer edges of the wafer will have a tendency to have less thickness (when coating) and more thickness (when etching) than the remaining surface areas of the wafer. This reduces the amount of the surface area on the wafer which has uniform thickness and accordingly can result in a lesser yield from the overall semiconductor wafer.

In the past, process parameters have been changed, different types of electrode materials have been used, and coating the surfaces of the electrodes themselves with a specialized coating such as pyrolytic graphite or silicon carbide. In cases where a special coating on the electrode has been used, the special coating can be etched away and the electrode then needs to be re-coated or replaced. Such practices can be expensive and time-consuming.

An additional problem with existing practice has been the use of relatively large diameter supporting pins employed to support the semiconductor wafers on the front and/or back surfaces of the electrode members during chemical vapor deposition or etching treatment. These existing support pins, while satisfactory in many respects, do result in casting a shadow on the surface of the semiconductor wafer being treated which, of course, adversely affects surface uniformity.

In order to overcome the above defects and problems encountered with existing practice, the present invention was devised.

## SUMMARY OF INVENTION

According to the present invention, a new and improved electrode design is provided for use in plasma enhanced chemical vapor deposition/etching operations. In the new electrode, approximately a 1/16 of an inch wide, circumferential region is formed around the outer periphery of the electrode members used to support semiconductor wafers during the treatment process. This reduced thickness circumferential region is sufficiently wide to undercut or underlie the circumferential edge portion of the semiconductor wafer being treated. Also, on the outer edge of the reduced thickness circumferential region portion of the electrode, the electrode itself can be notched or alternately provided with an annular array of mesa-like, separated, increased thickness island areas which are external of the reduced thickness circumferential region and exterior of the outer circumferential edge of a wafer being treated. These features combine to produce a stronger electric plasma field density throughout the peripheral edge portion of a semiconductor wafer being treated and thus causes the resulting coating or etching action to be more uniform around the outside edges where normally it will be thinner when coating or thicker when etching. Other similar techniques for increasing the electric field density around the circumferential edge portions of the semiconductor wafer being treated will be suggested to those skilled in the art in the light of these teachings.

A further feature of the invention is the provision of a set of two spaced-apart, low shadow effect, triangular-shaped wafer support elements secured to the outer periphery of the electrode member on a chord below and parallel to a line through the center of the electrode member for providing pin-like support for the wafers to be treated while holding the wafers in close electrical and physical contact with the wafer support surface of the electrode member without introducing substantial electric field shadow effects on the surface of the wafers being treated.

## BRIEF DESCRIPTION OF DRAWINGS

Other objects, features and many of the attendant advantages of this invention will become better understood from a reading of the following detailed description, wherein like parts in each of the several figures of the drawings are identified with the same reference character, and wherein:

Figure 1A is a plan front view of a prior art electrode structure which embodies known practices;

Figure 1B is a partial sectional view of Figure 1A and illustrates the construction of the relatively massive wafer pin support employed in this prior art electrode;

Figure 2A is a front plan view of a new and improved, dual-sided, electrode member constructed according to the invention;

Figure 2B is a back plan view of the dual-sided electrode member shown in Figure 2A;

Figure 2C is a partial planar view of the electrode shown in Figure 2A and 2B and illustrates in greater detail the construction of a low shadow effect triangular support pin construction according to the invention;

Figure 2D is a cross-sectional view through plane 2D-2D of Figure 2C of the drawing;

Figure 2E is a side view of the electrode shown in Figures 2A and 2B;

Figure 3A is a planar front view of an alternative embodiment of an improved electrode structure according to the invention;

Figure 3B is a back planar view of the electrode structure shown in Figure 3A;

Figure 3C is a partial, fragmentary view of a circumferential edge portion of the structure shown in Figure 3A and illustrates the nature of the notches formed in the outer periphery of the electrode member;

Figure 4A is a front planar view of still another embodiment of the invention;

Figure 4B is a back planar view of the embodiment of the invention shown in Figure 4A;

Figure 4C is a partial, fragmentary view of a triangular shaped low shadow effect pin support having somewhat different configuration from that shown in Figure 2C and 3C;

Figure 5A is a front planar view of a plate electrode member constructed according to the invention;

Figure 5B is a partial cross-sectional view through a portion of Figure 5A and illustrates the nature of the wafer pin supports employed in the embodiment of the invention shown in Figure 5A using support pins having tapered side edges; and

Figure 6 is a planar front view of a preferred embodiment of a plate electrode constructed in accordance with the present invention that uses triangular-shaped support pins.

BEST MODE OF PRACTICING INVENTION

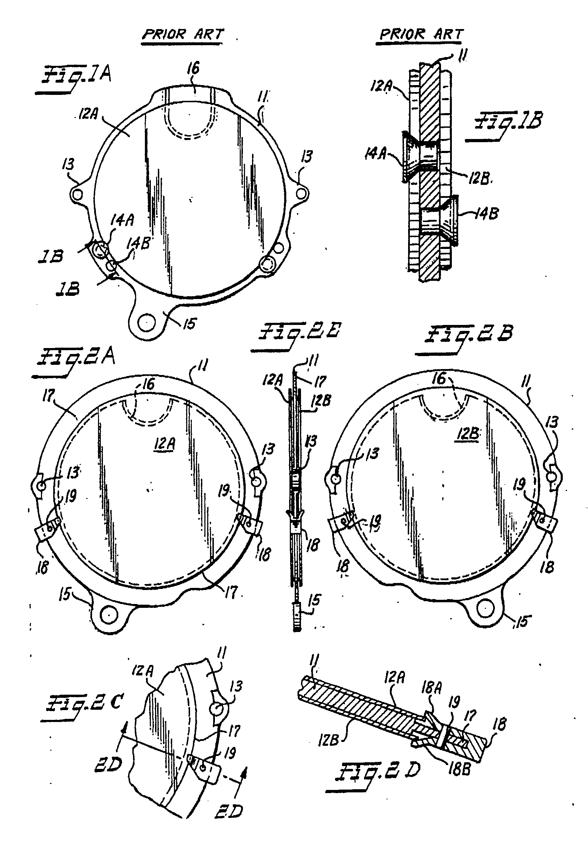

Figure 1A is a plan view of a prior art plasma enhanced chemical vapor deposition/etching electrode member of the type that has been used in the past with a disk boat assembly such as that described in U.S. Patent No. 4,610,748 - issued September 9, 1986, for "Apparatus for Processing Semiconductor Wafers or the Like", George M. Engle and Richard S. Rosler, inventors and in U.S. Patent Application Serial. No. 07/204,210 - filed June 8, 1988 - George M. Engle, inventor for "Plasma Enhanced Chemical Vapor Deposition Wafer holding Fixture". In such processing apparatus, circular disk-like semiconductor wafers are physically supported on one or both broad surfaces of the circular electrode member 11 as shown in Figures 1A and 1B at 12A. A second semiconductor wafer is shown at 12B, supported on the back side of the electrode member 11 in Figure 1B of the drawings. The semiconductor wafers 12A and 12B are physically held in good electrical contact with the front and back sides of the electrode member 11 by support pins 14A and 14B. Pins 14A and 14B have inwardly tapered side surfaces which support the peripheral edges of the semiconductor wafer and tend to cause the wafers to slide inwardly toward and be maintained in close physical contact with the surfaces of the electrode member 11.

The electrode members 11 themselves are physically supported in assembled relation in a disk boat assembly by a set of diametrically opposed support ears 13 that are integrally formed on the electrode members. Different electric potentials are supplied to alternate ones of the electrode members 11 by means of an electric conductor terminal ear 15 which is integrally formed with the electrode member 11. The terminal ears 15 are arranged such that different polarity electric potentials can be applied to alternate ones of the electrode members 11 in the boat assembly as described more fully in the above-referenced U.S. Patent No. 4,610,748 and U.S. Patent Application Serial No. 07/204,210.

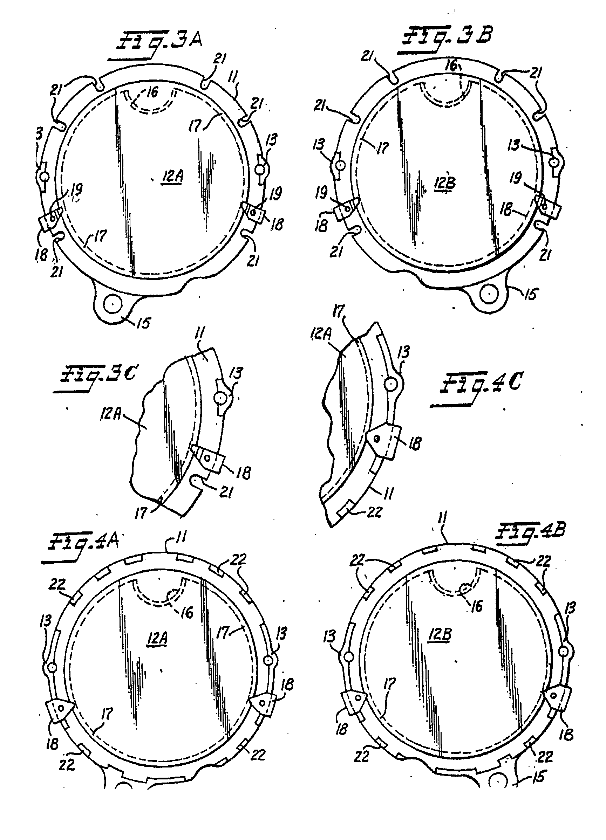

As noted earlier above, when coating or etching a semiconductor wafer placed on the electrically conductive electrode member 11 of the type shown in Figures 1A and 1B, the outer edges of the wafer will have a tendency to have less thickness (when coating) and more thickness (when etching) than the remaining surface areas of the semiconductor wafer. This tendency reduces the amount of the total area which has uniform thickness and therefore affects the yield of useful circuit devices that can be obtained from a wafer of any given size. In the past, process parameters have been changed, different types of electrode materials and coatings for the electrodes themselves have been tried. These attempts have helped a little, but not nearly as great as modifying the physical construction of the electrode itself as described hereinafter with relation to several embodiments of the invention disclosed in figures 2 through 6 of the drawings.

Figures 2A, 2B, 2C, 2D, and 2E illustrate a preferred embodiment of the invention as applied to a circular, disk-shape electrode member 11 suitable for installation and use in a boat assembly of the type described in the above-noted U.S. Patent No. 4,610,748 and U.S. Patent Application Serial No. 07/204,210. Figure 2A is a front plan view of a new and improved plasma enhanced chemical vapor deposition/etching, circular electrode member 11 preferably fabricated from pure graphite. The member 11 includes a set of electrode support regions in the form of ears 13 and an electric conductor connector terminal region in the form of an ear 15 and is machined from a square blank relatively thin (about 1/8 of an inch) of dense, relatively hard graphite to provide it with the physical features illustrated and to be described hereinafter. The electrode member could be fabricated by pre-casting and subsequent firing and polishing in accordance with known ceramic techniques; however, machining from a blank stock member, as briefly described above, has been demonstrated to be a preferred method of manufacture.

The principal feature of construction to be noted in Figure 2A through 2E of the drawings is the provision of a reduced thickness, circumferential electrode region 17 that completely surrounds the periphery of the circular semiconductor wafers 12A and 12B mounted on either side of the electrode member 11. In addition, it has been demonstrated that improved uniformity of deposition/etching can be obtained with regard to the entire exposed surface area of wafer 12A, 12B, if the reduced thickness portion of electrode member 11 extends under the circumferential edge portion of the wafers 12A, 12B, by a finite amount, of the order of 1/16 of an inch, as best illustrated in Figure 2C of the drawing, 2D and 2E of the drawings. The circumferential reduced thickness region, referred to as a "well" region, thus provided results in the formation of relatively shallow trench-like moat of about 1/16 and 1/32 of an inch in depth, completely surrounding the circumferential edge portion of semiconductor wafers 12A, 12B being processed. It is the formation of a "well" or "moat" underlying the circumferential edge portion of the semiconductor wafers being processed that results in the production of increased electric field force density acting at the edge portion of the wafers and which results in improved deposition/etching uniformity over the entire exposed surface area of the wafers 12A and 12B. To maintain the structural strength of the electrode, the regions of the electrode where the support ears 13 and electric connector terminal 15 are formed are maintained at the nominal original thickness of the electrode members as best depicted in Figure 2E of the drawings.

As stated earlier in the specification, the presence of the larger diameter wafer support pins 14A and 14B with their tapered side surface, as shown in the prior art structures of Figures 1A and 1B, tends to produce shadow effects on the near surfaces of the semiconductor wafers being treated. The shadow effects thus introduced of course adversely affect uniformity of treatment during plasma enhanced chemical vapor deposition/etching of the wafers. To reduce the shadow effects thus induced, an improved wafer pin support structure shown at 18 in Figures 2A through 2E of the drawing is employed as part of the present invention.

The construction of the reduced shadow effect wafer pin supports 18 is best shown in Figures 2C and 2D of the drawing. The improved wafer support pin 18 is comprised by a clip like body member having outwardly diverging, triangular-shape wafer supporting arms 18A and 18B which are slipped over the reduced thickness circumferential region 17 of the electrode members 11. After placement, the support pins 18 are secured in place by a very small cylindrical pin 19. The wafer support pin 18 and its integrally formed outwardly extending arms 18A and 18B, as well as pin 19, are formed of pure hardened graphite. As best shown in Figure 2C, the triangular shape of the wafer support arms 18A, 18B come to an essentially pin point engagement with the circumferential edges of the wafers 12A and 12B as shown in 2D. By this construction, the reduced mass of the triangular shaped wafer support pin greatly reduces any shadow effect that might be induced on the surface of the wafers 12A and 12B being treated. This reduction is induced shadow effect of the wafer support pin further results in an increase in uniformity of deposition or etching action with respect to the overall surface of wafers being treated.

While reviewing the embodiment of the invention shown in figures 2A through 2B, it should be noted that the support ears 13 for securing the electrode members 11 in a boat assembly are located on a center line axis drawn through the center of the circular-shaped electrode. The wafer support pins 13 are located on a rhumb line that runs parallel to the center line axis through the support ears 13 and below the center line axis. By construction in this manner, the wafer support pin will hold the wafers in close physical and electrical contact with the main wafer supporting surfaces of electrode 11, but assure that the wafers will not drop off due to the increased diameter portion thereof located above the support pins 18. Proper mounting of the electrode in the boat assembly in this manner will locate the tweezer pocket 16 at the upper peripheral edge of the electrode so that a technician easily may remove and replace wafers 12A or 12B with a set of tweezers slipped down through the pocket on each side of the wafer while it is supported in the manner shown in Figures 2A and 2B.

In comparing Figures 2A and 2B, it will be seen that the electric potential connector terminal 15 is located on a radius ont he lower side of the electrode member 11 when supported in a boat assembly. The radius on which electric connector terminal ear 15 is located forms an acute angle relative to the cross diameter axis through the support ears 13 other than a right angle. By this construction the ear 15 is located to the left of center while viewing the front of the electrode member 11 as shown in Figure 2A; and is located to the right of center when viewing the back side of the electrode as shown in Figure 2B. As a result, the electrode member 11 is universal in nature in that when positioned in a boat assembly, the electric potential supply terminal ear 15 can be located alternately to the left or right of the center of the electrode member 11 for connection to alternate polarity electric supply rods secured to alternate ones of electric supply terminal ears 15.

Figure 3A, 3B and 3C of the drawings illustrate an alternative embodiment of the invention wherein, in addition to the structure described above with relation to Figures 2A through 2E, the electrode member 11 has a plurality of notches or slots 21 cut into its periphery as shown. The particular number and depth of the slots or notches provided can be varied to achieve the desired purpose of shaping the plasma electric field in the vicinity of the periphery of the semiconductor wafers 12A or 12B being processed. For example, the notches 21 can be made to extend completely around the periphery of the electrode members 11 instead of the particular pattern shown in Figures 3A and 3B. Figure 3C of the drawings illustrate the relative size of the notches or slots compared to the size of the wafer support pins 18, and the desirability of providing at least two of the notches below the support pins to influence the electric field distribute in this region of the electrode.

Figures 4A, 4B, and 4C of the drawings illustrate an embodiment of the invention wherein the reduced thickness region 17 formed on the electrode member 11 is in the nature of a shallow trench-like moat completely surrounding the outer periphery of the electrode and having its inner diameter extending within and under the outer circumferential edge of a semiconductor wafer such as 12A or 12B supported on the electrode for treatment. The outermost circumferential edge of the trench-like moat is defined by a circular array of raised mesa-like increased thickness, spaced-apart island areas nobs 22, circularly arrayed around the outer periphery of the electrode and having a thickness corresponding in thickness to the centrally disposed wafer support surface of the electrode member. The number, spacing and size of the nobs 22 can be adjusted to provide the desired effect on the electric field force density produced by the electrode member in the region of the wafer circumferential edge.

Figure 5A is a front plan view of a different embodiment of the invention which is in the form of an elongated, rectangular-shape plate electrode member 23. The plate electrode member 23 preferably is fabricated from pure graphite using techniques similar to those described with relation to the above-disclosed circular shaped electrode members 11. The plate electrode 23 may have a thickness of the order of 3/16 to 1/8 inch and has a plurality of semiconductor wafer support surfaces 24 formed therein along its elongated axis. There may be 2, 4, 6, 8, etc. numbers of such pockets 24 formed in the plate electrode 23 depending upon the length of the plate and the diameter of the wafer support surfaces 24. For example, if the wafer support surfaces are for 150 millimeter diameter semiconductor wafers, the plate 23 may be roughly 6.5 inches in width, 38 inches in length, 3/4 inch thick, and be designed to support 8 (16 dual sided) wafers along its length.

The wafer support surfaces 24 along the length of the plate electrode member 23 are defined by a trench-like moat of reduced thickness having a notched outer circumferential edge 25 and an inner circular smooth edge 26. The inner smooth circumferential edge 26 of the wafer support surface 24 is designed to be slightly less than the outer circumferential edge 27 of a semiconductor wafer supported on the surface 24 thus defined. Similar semiconductor wafer support pockets 24 are formed on the back side of the plate 23 in corresponding position to that shown on the front side.

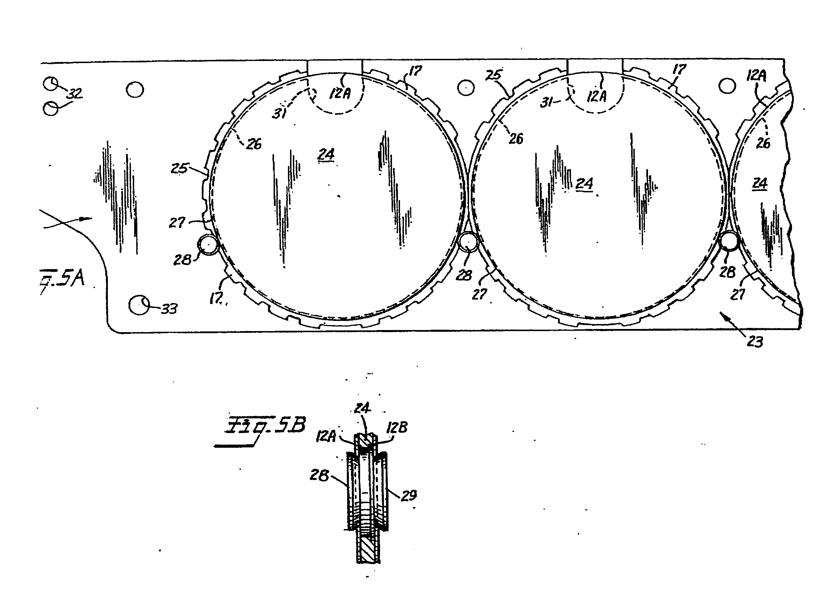

The semiconductor wafers 12A are held in place over the wafer support surfaces 24 by means of a plurality of wafer support pins 28, the construction of which may be similar to those shown in Figure 5B of the drawings. The wafer front side support pins 28 are integrally formed with the back side wafer support pins 29, and both are provided with tapered side surfaces which tend to hold the respective semiconductor wafers 12A or 12B in close physical and electrical contact with the intervening respective wafer support surfaces 24 of electrode member 23. A tweezer pocket 31 is formed in the top edge of the plate electrode member 23 and extends down into and below the region covered by the semiconductor wafer 12A.

The tweezer pocket is formed to the same depth as the depth of the moat defined between the circumferential edges 25 and 26, and defining the wafer support surface 24.

The plate electrode member 23 is designed to be mounted, along with other similar plate electrodes in a plate BOAT holding assembly for insertion in a plasma enhanced, chemical vapor deposition/etching equipment of known construction. For this purpose, suitable mounting apertures 33 are provided for support on mounting rods used in holding the plate electrodes 23 in assembled relation within a plate holding assembly. Electric potentials are applied to each plate member 23 by means of a conductive rod inserted into a connector opening shown at 32 formed in a dimpled left UPPER corner of plate 23 as shown in Figure 5A. By reversing alternate plates in the plate holding assembly so that the front side of one plate member 23 opposes the opposite or back side of the adjacent plate to it, alternate polarity electric potentials can be applied through the staggered connector openings 32 of the alternate plate members.

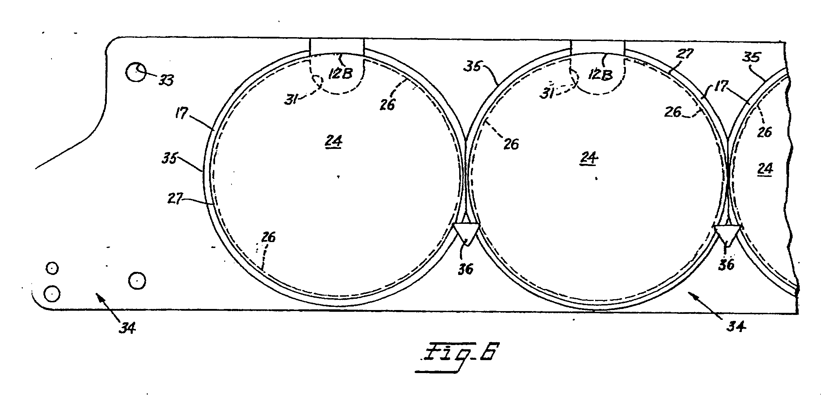

Figures 6 shows an alternative and preferred form of plate electrode construction 34 according to the invention. In Figure 6, the reduced thickness, trench-like moat 17 is defined by an outer circumferential, smooth, circular shaped wall 35 cut or otherwise formed into the surface of the plate electrode member 35 and an inner smooth, circular-shaped wall 26 which together define the central wafer supporting region 24 of nominal thickness to that of the plate electrode 34. The outer circumferential edge 27 of a semiconductor wafer supported on the electrode member is shown overlapping the inner circumferential edge 26 in a manner similar to that described with the embodiment of the invention shown in Figure 2A of the drawings. In other respects, the electrode member 34 employs triangular shaped semiconductor wafer support pins 36 to hold the semiconductor wafers 12B in place over the wafer support surfaces 24 in the same manner as the triangular shaped pins 18 described with relation to Figure 2A, 3A and 4A of the drawings. Here again, the tweezer pocket 31 is formed in the upper edge of the plate electrode member 34 to provide access for insertion and removal of the semiconductor wafers 12A or 12B on the front or back side of the plate electrode member 34.

In Figure 6, the back side the plate electrode member 34 has been illustrated in order to show how inverting alternate plates of the plate electrode members held in a plate BOAT assembly will serve to set apart or stagger the electric supply terminal receiving apertures 32 so that they are spaced above and below each other, allowing alternate plates to be excited with different polarity electric potentials.

## INDUSTRIAL APPLICABILITY

The invention provides a new plasma enhanced chemical vapor deposition/etching electrode for supporting semiconductor wafers within a gaseous plasma electric field for obtaining more uniform chemical vapor deposition or etching treatment of the surfaces of the semiconductor wafers during fabrication of integrated circuit semiconductor devices.

Having described several embodiments of a novel plasma enhanced chemical vapor deposition/etching electrode member for providing improved uniformity of deposition and/or etching during fabrication of integrated circuit semiconductor devices according to the invention, it is believed obvious that other modifications and variations of the invention will be suggested to those skilled in the art in the light of the above teachings. It is therefore to be understood that changes may be made in the particular embodiments of the invention disclosed which are within the full intended scope of the invention as defined by the appended claims.

## Claims

1. A new and improved plasma enhanced chemical vapor deposition etching electrode member for supporting semiconductor wafers within a gas plasma field for chemical vapor deposition or etching treatment;

said electrode member comprising a relatively flat member having electrically conductive surfaces and at least one centrally disposed wafer support surface formed thereon for receiving and supporting a complementary-shaped semi-conductor wafer for treatment;

said electrode member being suitably shaped in the area of the wafer support surface near but inside the circumferential edge of any wafer supported thereon to provide a reduced thickness circumferential electrode region whereby increased electric field force density is obtained around the circumferential regions of a wafer supported on the electrode during treatment and results in more uniform coating and etching of the semiconductor wafer in the circumferential edge regions thereof.

2. An electrode member according to claim 1 wherein the electrode member further includes on its outer periphery a set of spaced-apart mounting regions of substantially the same thickness as the centrally disposed wafer support surface for mounting the electrode member in a boat assembly, a tweezer pocket formed on both sides of the electrode member at a point on the outer periphery of the member intermediate the spaced-apart mounting regions, and an electric connector terminal region formed on the electrode member on the opposite side of the electrode member from the tweezer pocket on a radius forming an angle acute relative to a diameter extending through the tweezer pocket and normal to a diameter extending through the mounting ears.

3. An electrode member according to claim 1 wherein the reduced thickness region formed on the electrode member is in the nature of a shallow trench-like moat completely surrounding the outer periphery of the electrode and having its inner diameter extending within and under the outer circumferential edge of a semiconductor wafer supported on the electrode for treatment.

4. An electrode member according to claim 1 wherein the reduced thickness region around the circumferential edge of the electrode member includes a plurality of spaced-apart notches formed in the circumferential edge of the electrode member.

5. An electrode member according to claim 3 wherein the outer circumferential edge of the electrode member which defines the outermost circumferential edge of the trench-like moat includes an array of separate, raised, mesa-like, increased thickness knobs circularly arrayed around the outer periphery of the electrode and having a thickness corresponding in thickness to the centrally disposed wafer support surface formed on the electrode.

6. An electrode member according to claim 2 wherein the reduced thickness region formed on the electrode member is in the nature of a shallow trench-like moat completely surrounding the outer periphery of the electrode and having its inner diameter extending within and under the outer circumferential edge of a semiconductor wafer supported on the electrode for treatment.

7. An electrode member according to claim 2 wherein the outer circumferential edge of the electrode member which defines the outermost circumferential edge of the trench-like moat includes an array of separate, raised, mesa-like, increased thickness knobs circularly arrayed around the outer periphery of the electrode and having a thickness corresponding in thickness to the centrally disposed wafer support surface formed on the electrode.

8. An electrode member according to claim 1 wherein the electrode member is fabricated from a material consisting essentially of either pure graphite, or graphite coated with a special coating material of pyrolytic graphite, silicon carbide or the like.

9. An electrode member according to claim 6 wherein the electrode member is fabricated from a material consisting essentially of either pure graphite, or graphite coated with a special coating material of pyrolytic graphite, silicon carbide or the like.

10. An electrode member according to claim 7 wherein the electrode member is fabricated from a material consisting essentially of either pure graphite, or graphite coated with a special coating material of pyrolytic graphite, silicon carbide or the like.

11. An electrode member according to claim 1 wherein the electrode member is fabricated from a high temperature ceramic and provided with an electrically conductive surface coating.

12. An electrode member according to claim 6 wherein the electrode member is fabricated from a high temperature ceramic and provided with an electrically conductive surface coating.

13. An electrode member according to claim 4 wherein the electrode member is fabricated from a high temperature ceramic and provided with an electrically conductive surface coating.

14. An electrode member according to claim 7 wherein the electrode member is fabricated from a high temperature ceramic and provided with an electrically conductive surface coating.

15. An electrode member according to claim 1 wherein the electrode member is fabricated from a high temperature plastic material and is provided with an exterior electrically conductive coating.

16. An electrode member according to claim 6 wherein the electrode member is fabricated from a high temperature plastic material and is provided with an exterior electrically conductive coating.

17. An electrode member according to claim 4 wherein the electrode member is fabricated from a high temperature plastic material and is provided with an exterior electrically conductive coating.

18. An electrode member according to claim 7 wherein the electrode member is fabricated from a high temperature plastic material and is provided with an exterior electrically conductive coating.

19. An electrode member according to claim 1 wherein the electrode member further includes a set of two spaced-apart, low shadow effect, triangular-shaped wafer support elements secured to the outer periphery of the electrode member on a chord below and parallel to a line through the center of the electrode member for providing pin-like support for the wafers to be treated and holding the wafers in close electrical contact engagement with the wafer support surface of the electrode member whereby substantial electric field shadow effects on the surface of the wafers to be treated are avoided.

20. An electrode member according to claim 2 wherein the electrode member further includes a set of two spaced-apart, low shadow effect, triangular-shaped wafer support elements secured to the outer periphery of the electrode member on a chord below and parallel to a line through the center of the electrode member for providing pin-like support for the wafers to be treated and holding the wafers in close electrical contact engagement with the wafer support surface of the electrode member whereby substantial electric field shadow effects on the surface of the wafers to be treated are avoided.

21. An electrode member according to claim 9 wherein the electrode member further includes a set of two spaced-apart, low shadow effect, triangular-shaped wafer support elements secured to the outer periphery of the electrode member on a chord below and parallel to a line through the center of the electrode member for providing pin-like support for the wafers to be treated and holding the wafers in close electrical contact engagement with the wafer support surface of the electrode member whereby substantial electric field shadow effects on the surface of the wafers to be treated are avoided.

22. An electrode member according to claim 1 wherein the electrode member consists essentially of a round disk having centrally disposed wafer support surfaces formed on both of its flat sides.

23. An electrode member according to claim 21 wherein the electrode member consists essentially of a round disk having centrally disposed wafer support surfaces formed on both of its flat sides.

24. An electrode member according to claim 1 wherein the electrode member is generally rectangular in shape and has a plurality of spaced-apart, circular-shaped, wafer support surfaces centrally formed in a line along the elongate axis of the member on one or both its sides.

25. An electrode member according to claim 9 wherein the electrode member is generally rectangular in shape and has a plurality of spaced-apart, circular-shaped, wafer support surfaces centrally formed in a line along the elongate axis of the member on one or both its sides.

26. An electrode member according to claim 25 further including sets of two spaced-apart, low shadow effect, small diameter cylindrically shaped wafer support pin elements secured to the outer periphery of each of the circular-shaped wafer support surfaces formed on the elongate rectangular-shaped electrode member for providing pin-like support for the wafers to be treated and holding the wafers in close electrical contact engagement with the wafer support surface of the electrode member whereby substantial electric field shadow effects on the surface of the wafers to be treated are avoided.

27. A new and improved plasma enhanced chemical vapor deposition electrode member for supporting semiconductor wafers within a gas plasma field for chemical vapor deposition or etching treatment; said electrode member comprising a relatively flat member having electrically conductive surfaces and at least one centrally disposed wafer support surface formed thereon for receiving and supporting in close electrical contact at least one complementary-shaped semiconductor wafer for treatment; and

a set of two spaced-apart, low shadow effect, triangular-shaped wafer support elements secured to the outer periphery of the electrode member on a chord below and parallel to a line through the center of the electrode member for providing pin-like support for the wafers to be treated and holding the wafers in close electrical contact engagement with the wafer support surface of the electrode member whereby substantial electric field shadow effects on the surface of the wafers to be treated are avoided.

PRIOR ART

Fig.1A

PRIOR ART

Fig.1B

Fig.2E

Fig.2B

Fig.2A

Fig.2C

Fig.2D

Fig.3A

Fig.3B

Fig.3C

Fig.4C

Fig.4A

Fig.4B

Fig.5A

Fig.5B

EP 0 416 982 A2

Fig. 6